# EUROPEAN PATENT SPECIFICATION

(11) **EP 2 186 097 B1**
(45) Date of publication and mention of the grant of the patent: **13.06.2012**
(21) Application number: 08792810.7
(22) Date of filing: 27.08.2008
(51) Int. Cl.: G11C 19/28, G09G 3/20, G09G 3/36, G11C 19/00

(54) **SHIFT REGISTER, DISPLAY DRIVER AND DISPLAY**
SCHIEBEREGISTER, ANZEIGETREIBER UND DISPLAY
REGISTRE À DÉCALAGE, PILOTE D'AFFICHAGE ET AFFICHAGE

(30) Priority: 30.08.2007 GB 0716754
(43) Date of publication of application: 19.05.2010
(73) Proprietor: Sharp Kabushiki Kaisha, Osaka-shi, Osaka 545-8522 (JP)
(72) Inventor: ZEBEDEE, Patrick, Oxford, OX4 4GB (GB); JOHN, Gareth, Oxford, OX4 4GB (GB)
(74) Representative: Suckling, Andrew Michael
(86) International application number: PCT/JP2008/065789
(87) International publication number: WO 2009/028716

(56) References cited:
- WO-A1-2007/108177
- JP-A- 2002 197 885
- JP-A- 2006 260 621
- JP-A- 2007 257 812
- JP-A- 2008 058 939
- JP-A- 2008 140 490
- US-A1- 2005 179 677
- US-A1- 2006 181 502
- US-A1- 2006 210 012

## Description

### Technical Field

The present invention relates to a shift register and to a display driver and a display including such a shift register. Such a shift register may be used, for example, as or in a clock generator for driving rows and/or columns of an active matrix display.

### Background Art

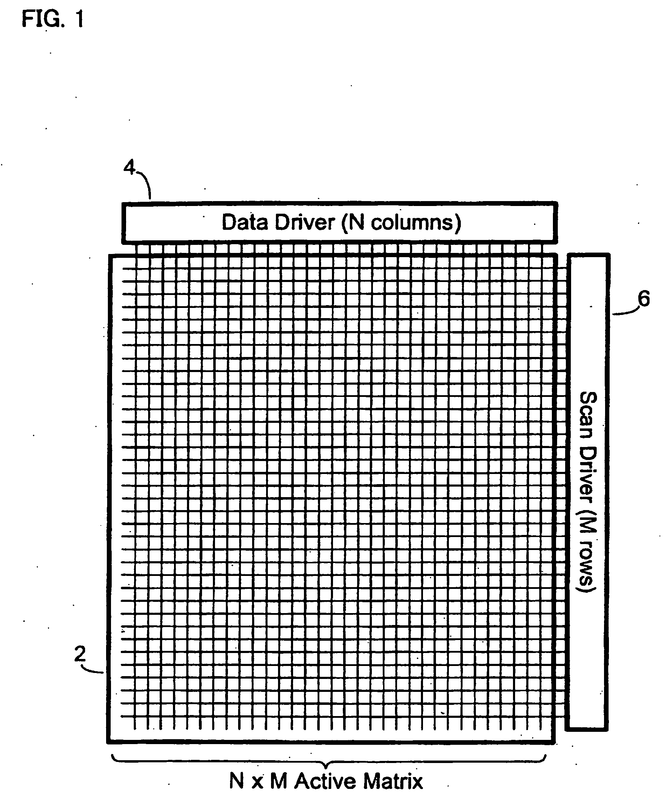

Figure 1 of the accompanying drawings shows a typical active matrix display. Such a display is made up of a matrix 2 of picture elements (pixels), arranged in M rows by N columns. Each row and column is connected to an electrode, with the column electrodes being connected to the N outputs of a data driver 4 and the row electrodes being connected to the M outputs of a scan driver 6.

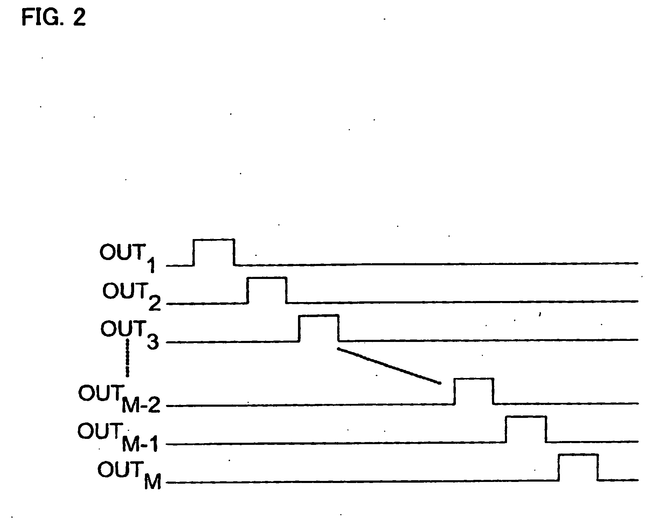

The pixels are addressed one row at a time. The scan driver includes an M-phase clock generator, which produces a series of clock pulses as shown in Figure 2 of the accompanying drawings. Each clock pulse OUTᵢ controls the activation of row i. It is usual for the pulses to be non-overlapping, such that no two pulses are high at the same time.

All the pixels of one row may be addressed simultaneously or they may be addressed in B blocks of b pixels, where bB = N. In the latter case, the data driver may also include a B-phase clock generator of the type described, such that each clock pulse OUTᵢ activates block i.

Scan drivers of the type described may be formed directly on a display substrate, reducing the number of connections required for the display. This is advantageous, since it reduces the area occupied by the connector and leads to a display which is more mechanically robust. In such cases, it is common to use a single type of transistor for the clock generator circuit. For example, the circuit may be composed of only n-type transistors rather than a mixture of n- and p-type transistors as commonly used in CMOS circuits. The use of a single type of transistor is advantageous for reducing manufacturing cost. However, it is difficult to design low-power, high-speed logic, such as AND gates and inverters, using a single type of transistor.

A clock generator for use in a scan driver may be formed from a shift register. A shift register is a multi-stage circuit capable of sequentially shifting a sequence of data from stage to stage along its length in response to a clock signal. In general, a shift register may shift an arbitrary sequence of data. However, when a shift register is used as a clock generator in a scan or data driver, it is only required to shift a single high state along its length. Such a shift register is referred to as a "walking one" shift register and may or may not be capable of shifting an arbitrary sequence of data.

An example of such a type of clock generator is disclosed in US6377099, and is shown in Figure 3 of the accompanying drawings. In this case, the flip-flop 24 is of the reset-set type (RSFF), with an additional gate 26 to control the passage of the clock such that the clock is passed to the output of the stage when the RSFF is set and the output is pulled to an inactive state when the RSFF is reset. The output of the gate is connected to the set input of the next stage and to the reset input of the previous stage. The output of the gate also forms an output of the scan driver.

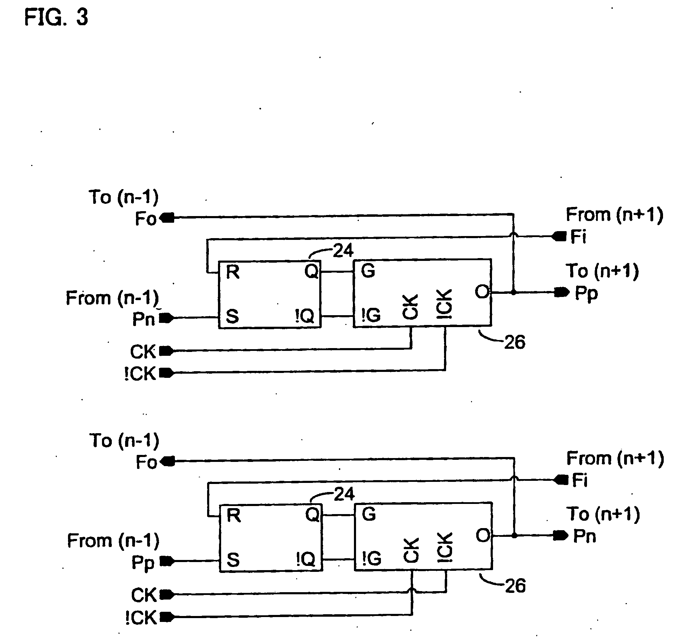

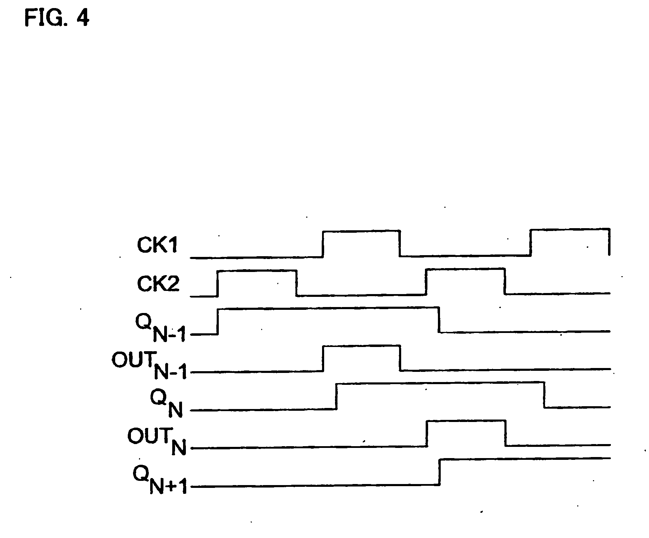

Figure 4 of the accompanying drawings illustrates the operation of the clock generator of Figure 3. Q_{N} represents the Q output of the RSFF, 24, of stage N; OUT_{N} represents the O output of the gate, 26, of stage N, which also forms an output of the scan driver. When stage N is set, Q_{N} rises to a high logic level and its gate, 26, passes the clock to the output. When the clock rises, OUT_{N} rises and this sets stage N+1 and resets stage N-1, such that Q_{N+1} rises to a high logic level and Q_{N-1} falls to a low logic level. Stage N+1 is configured to pass the complement of the clock to its output, so the output initially remains low. When the clock falls, the output of stage N falls and the output of stage N+1 rises. This resets stage N, preventing subsequent clock pulses from being passed to its output, and sets stage N+2.

US6724361 describes a similar circuit, used with non-overlapping rather than complementary clocks. In this case, the outputs of the register are non-overlapping. The operation of the circuit is otherwise similar.

Another type of scan driver is disclosed in US6845140, and is shown in Figure 5 of the accompanying drawings. The output stage (that is, the stage that drives the scan driver output, GOUT), is composed of two transistors, 10 and 12. These transistors are controlled by the shift register logic, 14, such that transistor 10 passes the clock, CK, to the output when the stage is enabled (that is, when the Q output of the logic 14 is high and the QB output is low), and holds the output at the low supply voltage, Voff, when the stage is disabled (when the Q output of the logic 14 is low and the QB output is high). The operation of the circuit is broadly similar to that described in US6377099.

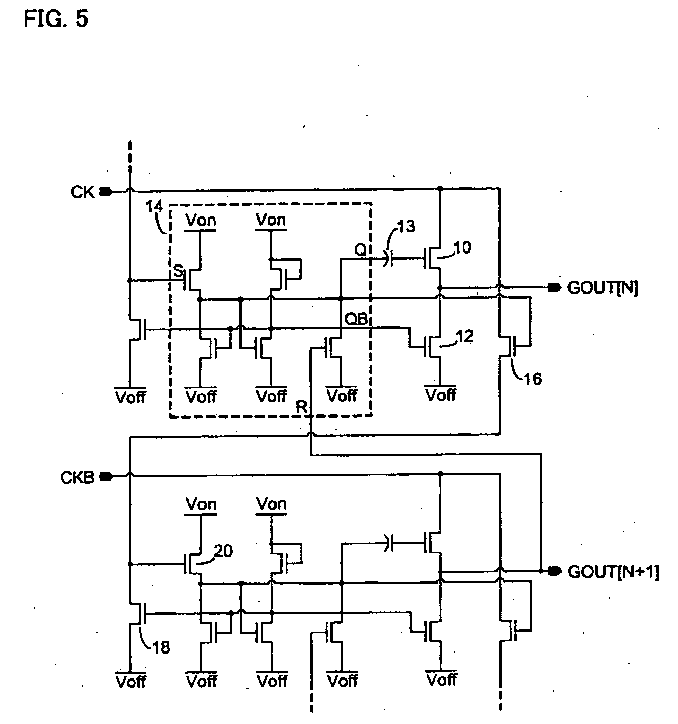

The scan driver of Figure 5 also includes a carry output, composed of transistors 16 and 18. When stage N is enabled, transistor 16 of stage N passes the clock to stage N+1, where it serves to enable stage N+1; transistor 18 holds the gate of transistor 20 at Voff when stage N+ 1 is disabled. The carry output is controlled by stage N and stage N+1: transistor 16 of stage N is controlled by an output of the logic of stage N, while transistor 18 of stage N is controlled by an output of the logic of stage N+1.

Stage N is disabled by the scan driver output of stage N+1, GOUT[N+1], and not by its carry output.

The scan driver output may be connected to a substantial capacitive load, such that the scan driver output may have a long rise time. The use of a separate carry output serves to isolate the logic of the next stage from the scan driver output, such that this rise time has a reduced effect on the operation of the logic. However, a disadvantage of the architecture described in US6845140 is that, when the carry output of stage N first rises, stage N+1 is still disabled and transistor 18 is conducting. There is therefore a direct connection between the clock and Voff. This connection causes a short-circuit current to flow, increasing the load on the clock driver and increasing the power consumption of the circuit.

The circuit described in US6845140 is composed of only n-type transistors as shown in Figure 5. The output stage used is common in such circuits: it is composed of two transistors, 10 and 12, and a bootstrap capacitor, 13. The transistors are controlled by the logic such that exactly one transistor is activated at any time. The first transistor, 10, passes the clock directly to the output, with no additional logic or buffering; the second, 12, pulls the output to a low supply voltage.

The voltage at the source of an n-type transistor is normally no higher than V_{G} - V_{TH}, where V_{G} is the gate voltage of the transistor and V_{TH} is the threshold voltage of the transistor. The output of the logic, which supplies V_{G} to the output switches, is, in turn, no higher than Von, the high supply voltage, and is commonly no higher than Von - V_{TH}, for similar reasons (it is generated by a transistor whose gate is no higher than V_{ON}). It is preferable to pass the full voltage of the clock to the output (otherwise, it would be necessary to increase the voltage of the clock, which leads to higher power consumption). This requires a gate voltage of at least V_{CKH} + V_{TH}, where V_{CKH} is the clock high voltage (commonly equal to Von).

The bootstrap capacitor, 13, acts to increase the gate voltage of the first transistor when the clock rises. Its operation is as follows: the gate of transistor 10 is raised by the logic to a point where it conducts; when the clock rises, the rise is conducted to the output; this rise is coupled to the gate of transistor 10 by the capacitor 13, increasing the gate voltage, and ensuring that transistor 10 continues to conduct until its source and drain voltages are substantially equal.

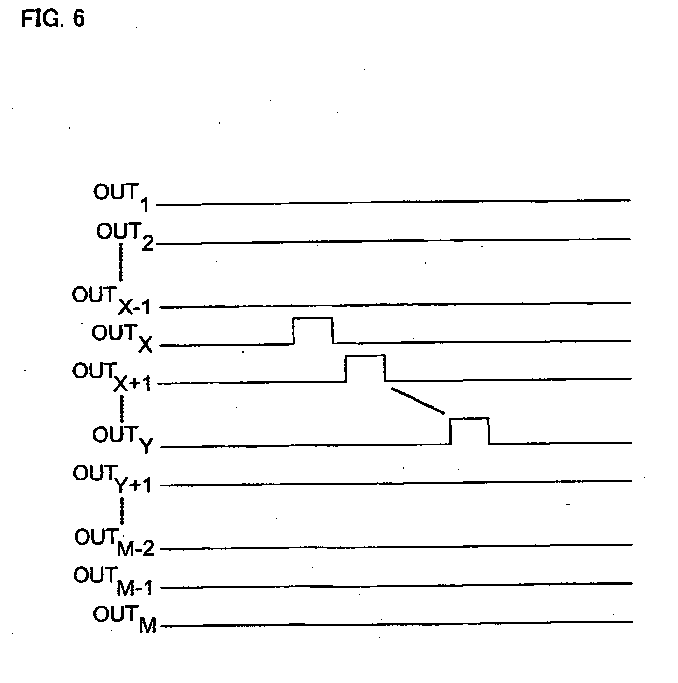

It is a common requirement for small displays to have a mode where only a portion of the display is refreshed. This is often used to give low power, for example when the display is showing a stand-by image on a limited number of rows. In this case, only the rows corresponding to the partial image are refreshed during every scan. The full screen of the display is refreshed less frequently. Figure 6 of the accompanying drawings shows the outputs of the scan driver during a frame when only the partial image is being refreshed. Rows X to Y are activated in turn; other rows are not activated. In this case, the partial image would cover row X to row Y.

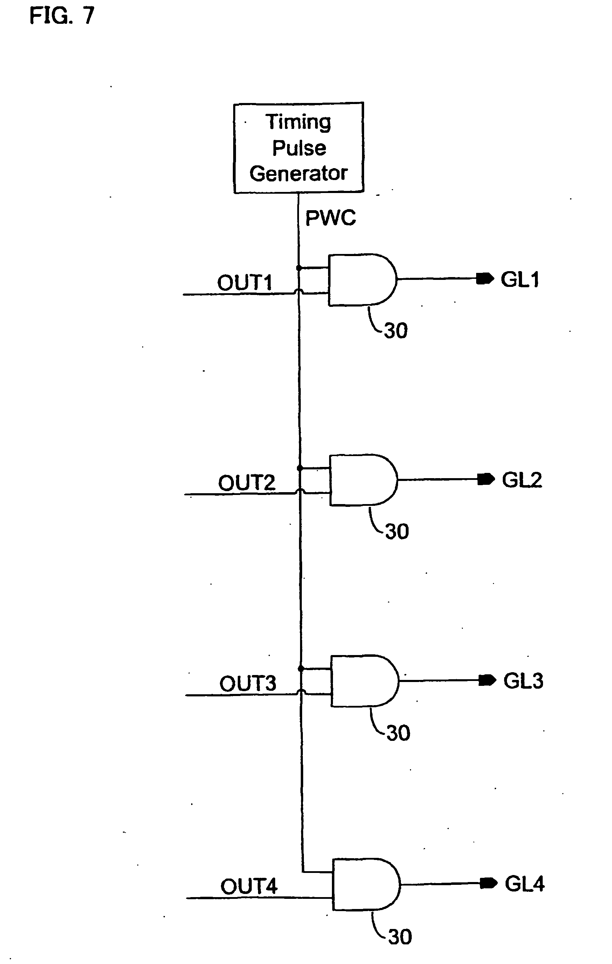

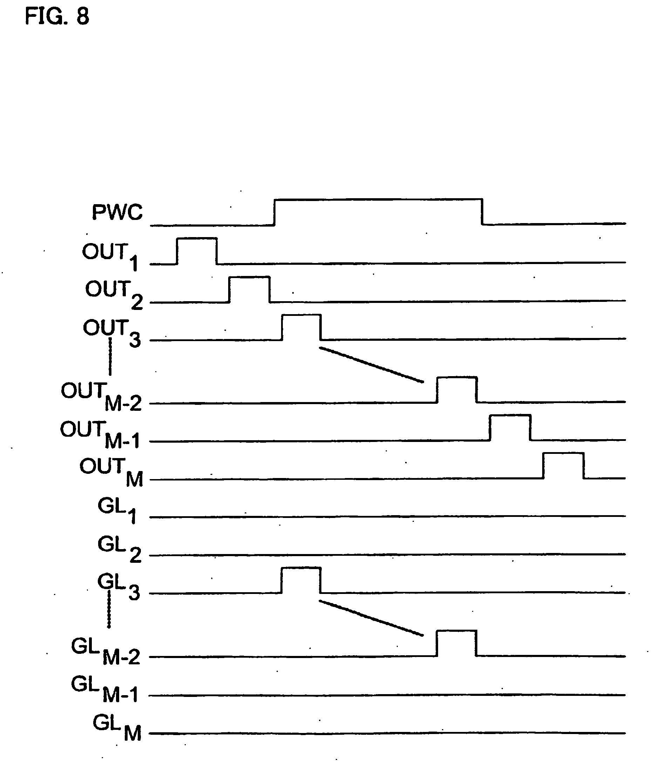

A known method of implementing such a partial function is shown in Figure 7 of the accompanying drawings; its operation is illustrated in Figure 8 of the accompanying drawings. The outputs of the shift register are logically combined with an additional signal PWC using an AND gate 30 such that, when PWC is high, the shift register outputs are passed to the scan driver outputs but, when PWC is low, the scan driver outputs are held low. It is usual to buffer the output of the AND gate, using inverters of increasing size, such that it is able to drive the load presented by the row electrode of the display in a sufficiently short time. This approach is therefore not suitable for scan drivers formed from a single type of transistor.

US2006/0181502 proposes a shift register in which each stage has a logic circuit and single output circuit. The logic circuit of a stage is connected to an output of a following stage logic circuit, and to the output circuit for connection to a load.

US 2005/0179677 proposes a shift register in which each stage has a logic circuit and single output circuit. The logic circuit of a stage is connected to an input of a following stage logic circuit, and to the output circuit for connection to a load.

US 2006/0210012 proposes a shift register formed of a plurality of cascade-connected shift blocks. Each shift block has a first output and a second output, with the second output being connected to an input of the next shift block and to a reset input of the previous block. The phases of clock signals applied to an even-numbered shift .block are reversed compared to the phases of clock signals applied to an odd-numbered shift block.

According to the invention there is provided a shift register comprising a plurality of stages arranged to be activated in sequence, each stage comprising a logic circuit controlling first and second output circuits, the first output circuit comprising a stage output for supplying an output signal of the stage and the second output circuit comprising a further output of the stage connected to an set input of the logic circuit of a succeeding stage and connected to a reset input of the logic circuit of a preceding stage, the first output circuit comprising a first switch, which connects the stage output to a first active signal input of the stage when the stage is active, and a second switch, which connects the stage output to a first inactive signal input of the stage when the stage is inactive, the first active signal inputs of at least some of the stages being connected to at least one pulse width control input of the register for receiving at least one pulse width control signal for determining which of the stages is enabled; wherein the second output circuit comprises a third switch, which connects the further output of the stage to a second active signal input of the stage when the stage is active, and a fourth switch, which connects the further output to a second inactive signal input of the stage when the stage is inactive; and wherein the second active signal input is connected to at least one clock input of the register.

The first active signal inputs of at least some of the stages may be connected to at least one clock input of the register.

The first inactive signal inputs of at least some of the stages may be connected to a control input of the shift register for receiving an inactive signal level in a first mode of operation and an active signal level in a second mode of operation for activating the stage outputs of the at least some stages simultaneously. As an alternative, the first inactive signal inputs may be connected to receive an inactive signal level.

The second inactive signal inputs may be connected to receive an inactive signal level.

Each of the switches may comprise an amplifying device. Each of the amplifying devices may comprise a transistor. The amplifying device constituting the first switch may be provided with a first bootstrap capacitor. The amplifying device constituting the third switch may be provided with a second bootstrap capacitor. The amplifying device constituting the second switch may be provided with a third bootstrap capacitor.

Each of the logic circuits may comprise a reset-set flip-flop.

According to an embodiment of the invention there is provided a display driver comprising a shift register according to the invention.

According to a further embodiment of the invention, there is provided an active matrix display including a display driver of the invention.

The display may comprise a liquid crystal display.

The display may comprise addressing electrodes connected to the stage outputs.

It is thus possible to provide a shift register in which adjacent stages are substantially isolated from the stage output of each stage. Thus, operation of the shift register is not substantially affected by the load presented to each stage output. For example, operation is not substantially affected by changes in rise times of signals at the stage outputs caused by capacitive loading.

It is possible to activate only some of the outputs without the need for additional logic gates or buffering. This is advantageous, for example, when the circuitry comprises transistors of a single conductivity type.

### Brief Description of Drawings

Figure 1 is a block diagram illustrating a known type of active matrix display;
Figure 2 is a waveform diagram illustrating output pulses of a typical scan driver of the display in Figure 1;
Figure 3 is a block schematic diagram of a known type of scan driver;
Figure 4 is a waveform diagram illustrating the operation of the scan driver of Figure 3;
Figure 5 is a schematic diagram of two stages of a known type of scan driver;
Figure 6 is a waveform diagram illustrating scan driver output pulses in a partial mode of operation;
Figure 7 is a schematic diagram of a known type of scan driver;
Figure 8 is a waveform diagram illustrating the operation of the scan driver of Figure 7;
Figure 9 is a block schematic diagram of a multiple-stage scan driver ;
Figure 10 is a block schematic diagram of one of the stages of Figure 9;
Figure 11 is a block schematic diagram of one of the stages of Figure 9;
Figure 12 is a block schematic diagram of one of the stages of Figure 9;
Figure 13 is a block schematic diagram of a multiple-stage scan driver constituting an embodiment of the invention;
Figure 14 is a block schematic diagram of one of the stages of Figure 13;
Figure 15 is a waveform diagram illustrating the operation of the circuit in Figures 13 and 14 during a normal mode of operation;
Figure 16 is a waveform diagram illustrating the operation of the circuit in Figures 13 and 14 during a partial mode of operation;
Figure 17 is a block schematic diagram of another multiple-stage scan driver ;
Figure 18 is a block schematic diagram of one of the stages of Figure 17;
Figure 19 is a block schematic diagram of a multiple-stage scan driver constituting another embodiment of the invention; and
Figure 20 is a block schematic diagram of one of the stages of Figure 19.

### Best Mode for Carrying out the Invention

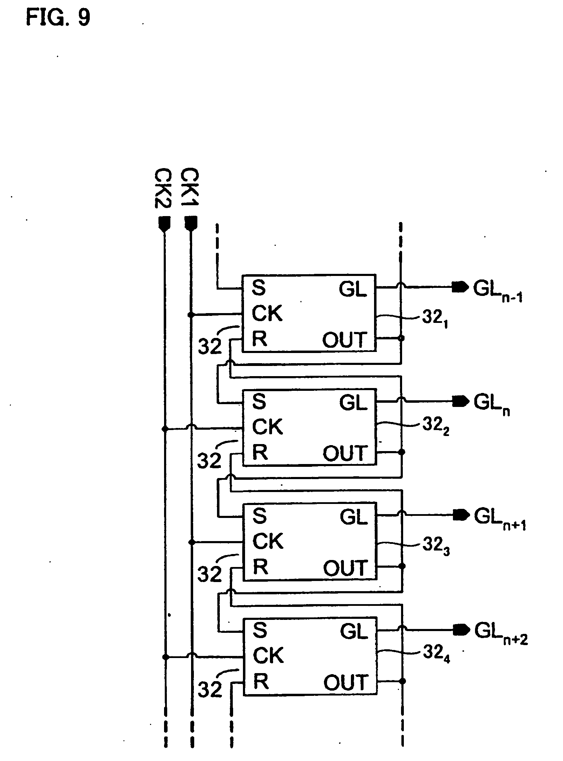

The scan drivers described hereinafter are for use as display drivers in an active matrix display, for example of the type shown in .Figure 1. The display may comprise a liquid crystal display and has addressing electrodes connected to stage outputs of the or each scan device. As shown in Figures 9 to 12, a first scan driver is in the form of a shift register and is composed of a number of stages, 32 arranged to be activated in sequence. Each stage has a reset input (R), a set input (S), and a clock input (CK). At least some of the stages are connected to receive pulse width control (PWC) signals from at least one pulse width control input of the scan driver. The PWC signals may be used to determine which stages are enabled in the sense of supplying an active output signal at the desired timing. The PWC arrangements are not shown in Figures 9 to 12 but are illustrated and described hereinafter.

The CK inputs of odd-number stages such as 32₁ and 32₃ are connected to a first clock, CK1; the CK inputs of even-number stages such as 32₂ and 32₄ are connected to a second clock, CK2. The clocks are preferably non-overlapping, such that the scan driver outputs are non-overlapping. However, the clocks may also be complementary, such that the scan driver outputs have coincident edges.

Each stage has two outputs: OUT and GL. The GL output of each stage forms an output of the driver, GLᵢ; the OUT output of each stage is connected to the S input of the succeeding stage and the R input of the preceding stage.

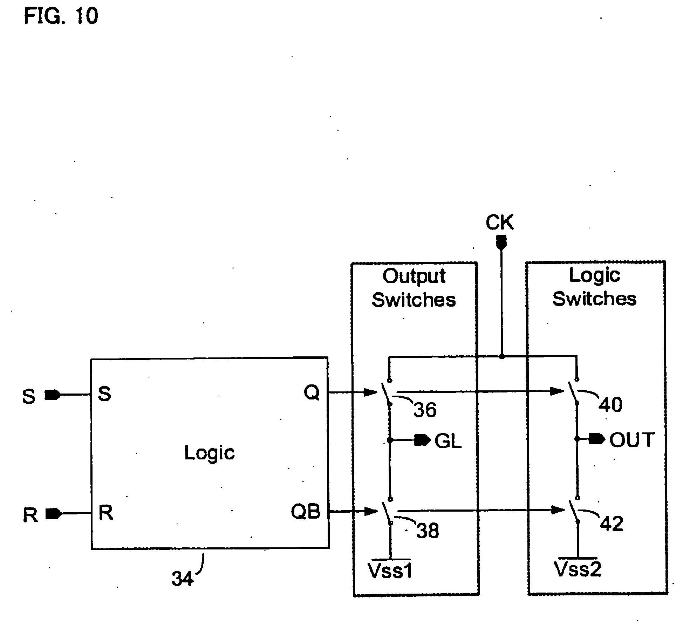

Figure 10 shows the composition of one of the stages, 32, of Figure 9, all of which are the same. This stage is composed of a logic circuit, 34, a first output circuit ("output switches") comprising first and second switches 46, 48, and a second output circuit ("logic switches") comprising third and fourth switches 50, 52. The switches may comprise amplifying devices such as transistors. The logic circuit has two inputs, S and R, which are connected to the S and R inputs of the stage, respectively, and two outputs Q and QB. The Q output is high when the logic is activated and low when it is deactivated; the QB output is the complement of Q. The logic circuit may be embodied as a reset-set flip-flop.

The Q output of the logic circuit is connected to the control terminals of the switches 36 and 40; the QB output is connected to the control terminals of the switches 38 and 42. The switch 36 is connected such that its principal conduction path is between the CK input and the GL output; the switch 40 is connected such that its principal conduction path is between the CK input and the OUT output; the switch 38 is connected such that its principal conduction path is between a low supply voltage, Vss1, and the GL output; the switch 42 is connected such that its principal conduction path is between a second low supply voltage Vss2 and the OUT output. Switches 36 and 38 therefore form the output switches, in that they drive the output of the scan driver; switches 40 and 42 form the logic switches, in that they drive the logic of other stages of the scan driver.

The operation of the circuit is similar to that described in US6377099. However, there is no connection between the GL outputs, and therefore the row electrodes of the display, and the logic of the succeeding or preceding stages. Therefore the operation of the shift register is not affected by, for example, the rise time of the row electrode. In addition, only one of the output switches and one of the logic switches is conducting at any time. This prevents a short circuit between the clock and a low power supply voltage.

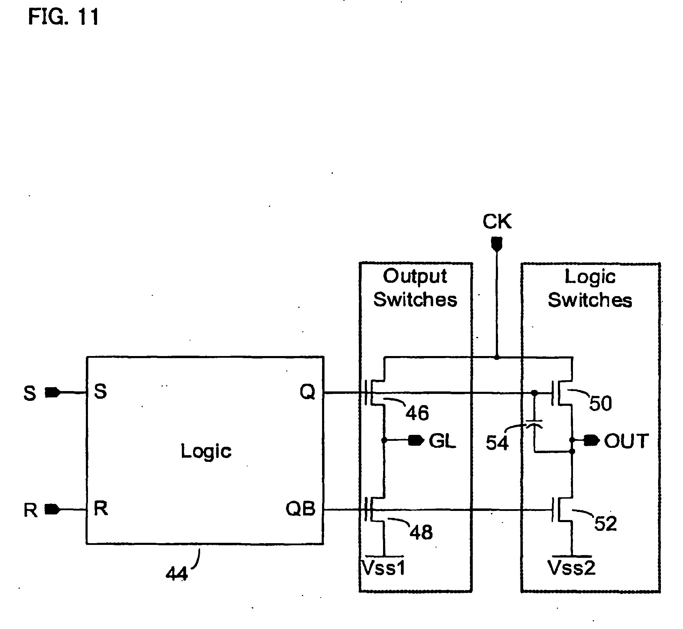

Figure 11 shows a transistor-level implementation of the stage of Figure 10. The scan driver is composed of n-type transistors only. The connections between the stages are as shown in Figure 9.

This stage is composed of a logic circuit, 44, four transistors 46, 48, 50, 52, and a bootstrap capacitor 54. The logic circuit has two inputs, S and R, which are connected to the S and R inputs of the stage, respectively, and two outputs Q and QB. The Q output is high when the logic circuit is activated and low when it is deactivated; the QB output is the complement of Q. The logic circuit may be of the form, 14, shown in Figure 5.

The Q output of the logic circuit is connected to the control terminals of the transistors 46 and 50; the QB output is connected to the control terminal of the transistors 48 and 52. The Transistor 46 is connected such that its principal conduction path is between the CK input and the GL output; the transistor 50 is connected such that its principal conduction path is between the CK input and the OUT output; the transistor 48 is connected such that its principal conduction path is between a low supply voltage, Vss1, and the GL output; the transistor 52 is connected such that its principal conduction path is between a second low supply voltage Vss2 and the OUT output. The transistors 46 and 48 therefore form the output switches and the transistors 50 and 52 form the logic switches.

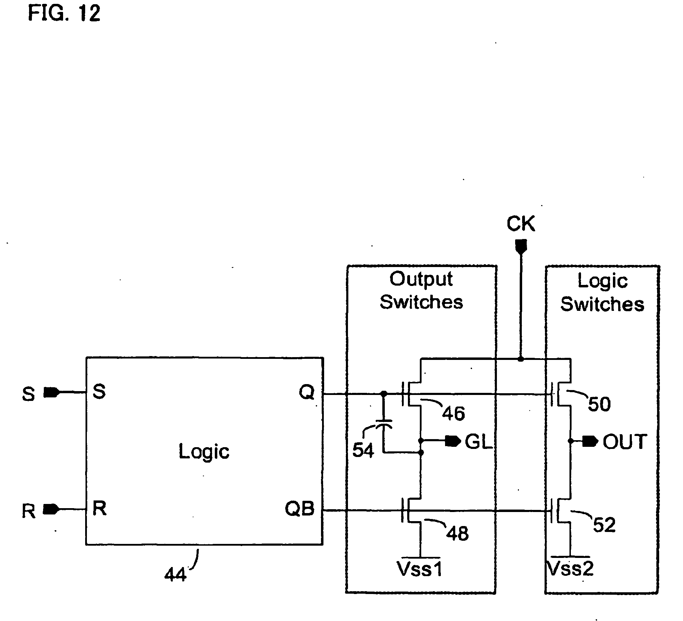

The bootstrap capacitor is preferably connected between the logic output, OUT, and the Q output of the logic circuit, and serves to ensure the voltage on the control electrodes of the transistors 46 and 50 is boosted to a level sufficient for the high level of the clock to conduct fully to the GL and OUT outputs. In this way, the operation of the bootstrap capacitor is not affected by, for example, the rise time of the GL output. However, it is also possible to connect the bootstrap capacitor between the GL output and the Q output of the logic, as shown in Figure 12.

Vss1 is preferably electrically connected to Vss2.

The remaining embodiments and examples concern the connections to the switches. They will be described using n-type transistors, but may equally well be applied to any type of switch.

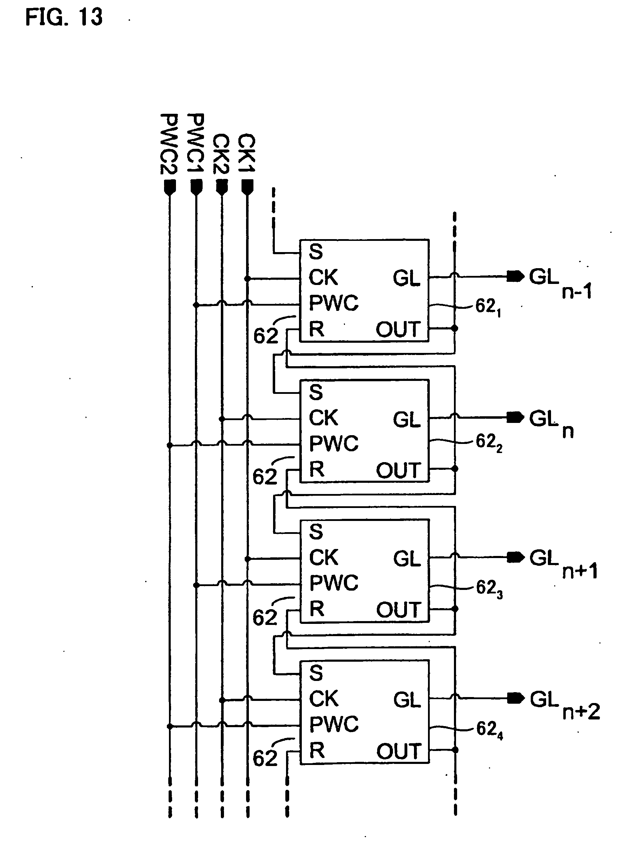

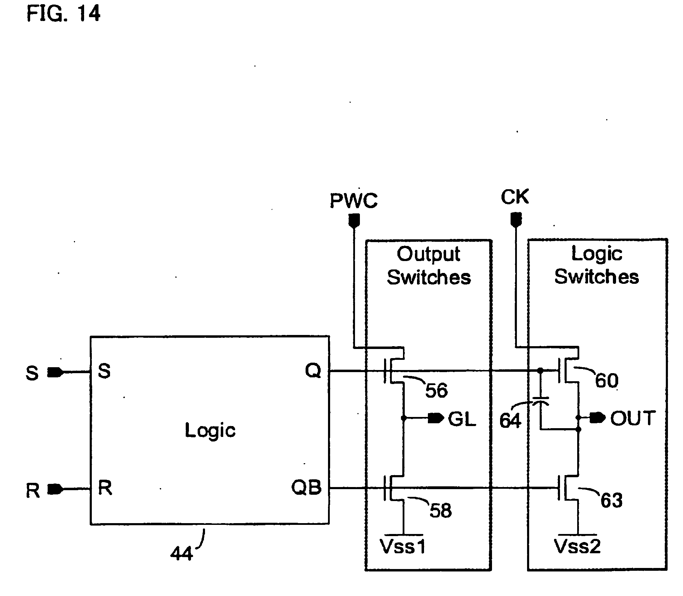

The scan driver shown in Figures 13 and 14 is composed of a number of stages, 62. Each stage has inputs R, S, CK and a pulse width control (PWC) input. The CK inputs of odd-number stages such as 62₁, and 62₃ are connected to a first clock, CK1; the CK inputs of even-number stages such as 62₂ and 62₄ are connected to a second clock, CK2. The PWC inputs of odd-number stages are connected to a first pulse width control signal, PWC1; the PWC inputs of even-number stages are connected to a second pulse width control signal, PWC2.

In Figure 14, each stage is composed of a logic circuit, 44, four transistors 56, 58, 60, 63, and a bootstrap capacitor 64. The logic circuit has two inputs, S and R, which are connected to the S and R inputs of the stage, respectively, and two outputs Q and QB. The Q output is high when the logic circuit is activated and low when it is deactivated; the QB output is the complement of Q. The logic circuit may be of the form, 14, shown in Figure 5.

The Q output of the logic circuit is connected to the control terminals of the transistors 56 and 60; the QB output is connected to the control terminals of the transistors 58 and 63. The transistor 56 is connected such that its principal conduction path is between the PWC input, which forms a first active signal input of the stage, and the GL output; the transistor 60 is connected such that its principal conduction path is between the CK input, which forms a second active signal input of the stage, and the OUT output; the transistor 58 is connected such that its principal conduction path is between a low supply voltage, Vss1, which forms a first inactive signal input of the stage, and the GL output; the transistor 63 is connected such that its principal conduction path is between a second low supply voltage, Vss2, which forms a second inactive signal input of the stage and, the OUT output. The Transistors 56 and 58 therefore form the output switches and the transistors 60 and 63 form the logic switches.

The bootstrap capacitor is preferably connected between the logic output, OUT, and the Q output of the logic circuit, and operates as previously described.

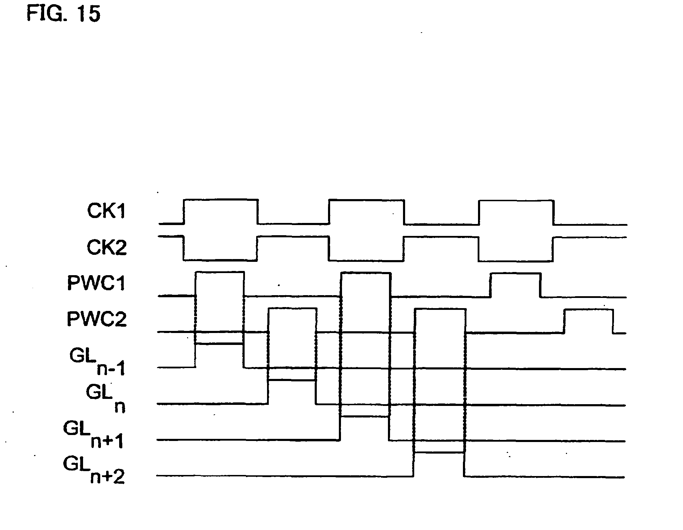

Figure 15 shows the timing of the signals for normal operation, when the full screen of the display is refreshed. The timing of the PWC signals corresponds to the desired timing of the scan driver output pulses: each stage passes one pulse of the corresponding PWC signal to the GL output. The timing of the PWC pulses does not have to be the same as the CK pulses: a PWC signal should rise coincident with or after the rise of the corresponding CK signal, so that the bootstrap capacitor can operate; it should fall coincident with or before the fall of the corresponding CK signal, since the falling edge of the clock will cause a reverse bootstrap effect, lowering the gate voltage of the transistors 58 and 60, and reducing their conductivity.

It is therefore possible for CK1 and CK2 to be complements of one another, as shown in Figure 15, or for them to be substantially the same as PWC1 and PWC2, respectively.

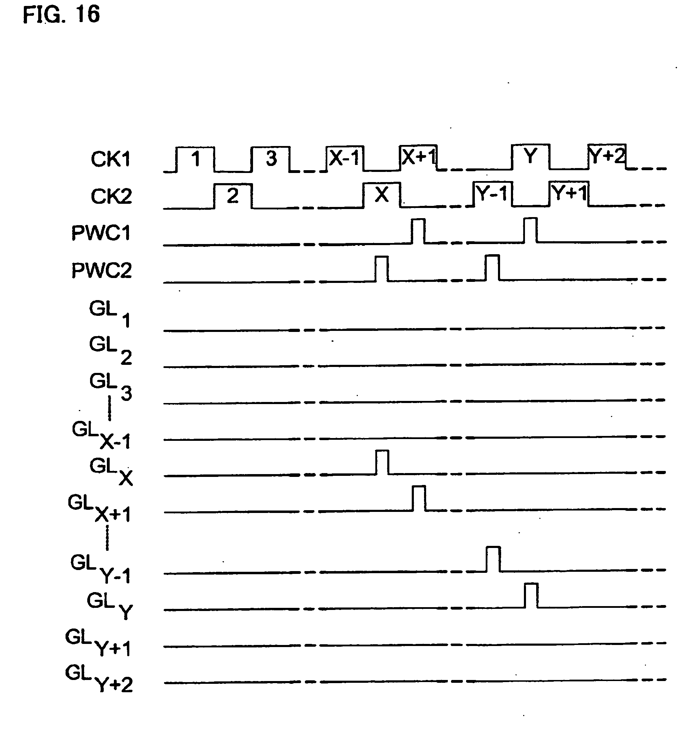

Figure 16 shows the timing of the signals for partial operation, when a limited number of rows is refreshed. In Figure 16, only rows X to Y are refreshed. In this case, the PWC signals are inactive during non-refreshed rows; during refreshed rows, their timing is as in Figure 15. Again, the clocks may be complementary, or the timing of their rising and falling edges may be similar to PWC1 and PWC2.

The PWC signals thus control which of the stages 62 are "enabled" in the sense of providing "active" output pulses at the stage outputs GLᵢ. Also, the widths of the output pulses are determined by the widths of the PWC signal pulses and may therefore be selected to be different from the widths of the clock pulses. For example, non-overlapping output pulses may be supplied using complementary clocks CK1 and CK2 having coincident clock pulse edges.

In the above embodiment and example, Vss1 may be electrically connected to Vss2.

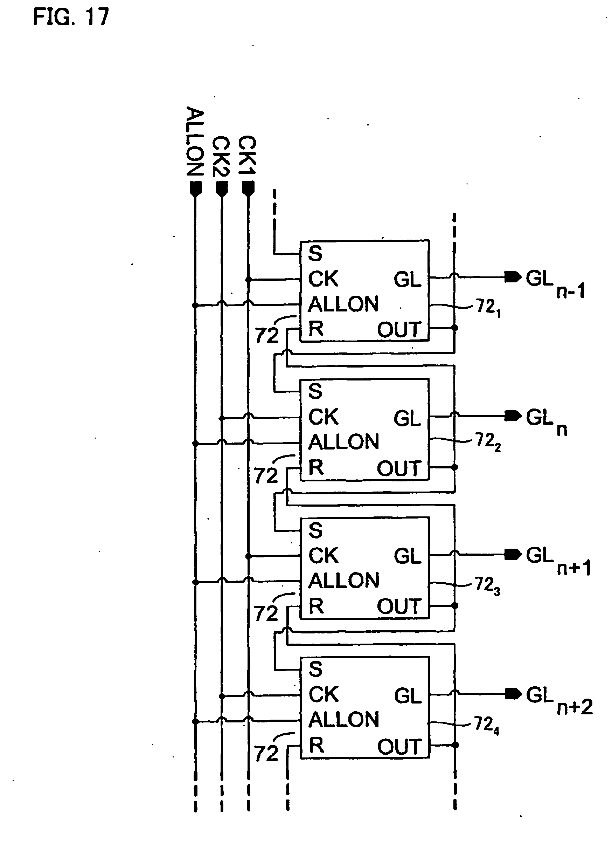

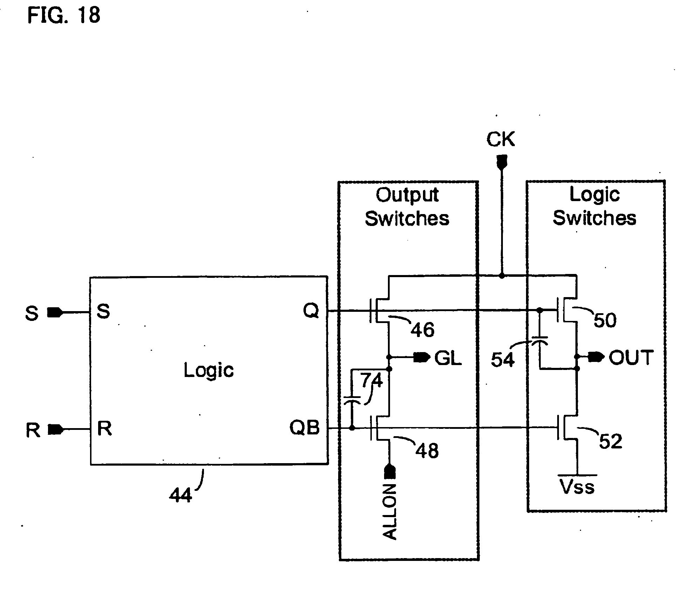

In some applications, it may be necessary or desirable to provide a scan driver with the capacity to activate some or all of its outputs at the same time ("all-on"). Arrangements for achieving this are shown in our co-pending British patent application no. GB 2452278/0716753.9 and an example of this is shown in Figures 17 and 18. The scan driver is composed of a number of stages, 72. Each stage has inputs R, S, CK and ALLON and a PWC input (now shown). The CK inputs of odd-number stages such as 72₁ and 72₃ are connected to a first clock, CK1; the CK inputs of even-number stages such as 72₂ and 72₄ are connected to a second clock, CK2. The ALLON inputs of all stages are connected to a signal ALLON.

Each stage is similar to that shown in Figure 10 and only the differences will be described. The transistor 48 is connected such that its principal conduction path is between the ALLON input and the GL output. In addition, there is a bootstrap capacitor 74 connected between the GL output and the QB output of the logic circuit. As before, this serves to ensure the voltage on the control electrode of the transistor 48 is boosted to a level sufficient for the high level of ALLON to conduct fully to the GL output.

In normal or "first" mode, ALLON is held at an inactive signal level in the form of a low voltage, such as Vss1, and the driver operates as described hereinbefore. In a "second" mode forming an "all on" mode, ALLON is held at an active signal level in the form of a high voltage.

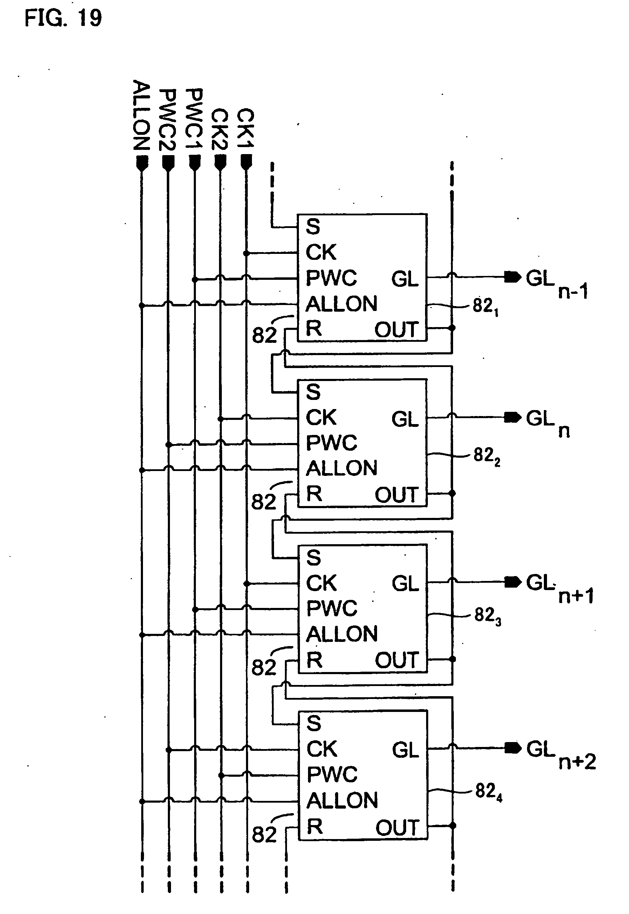

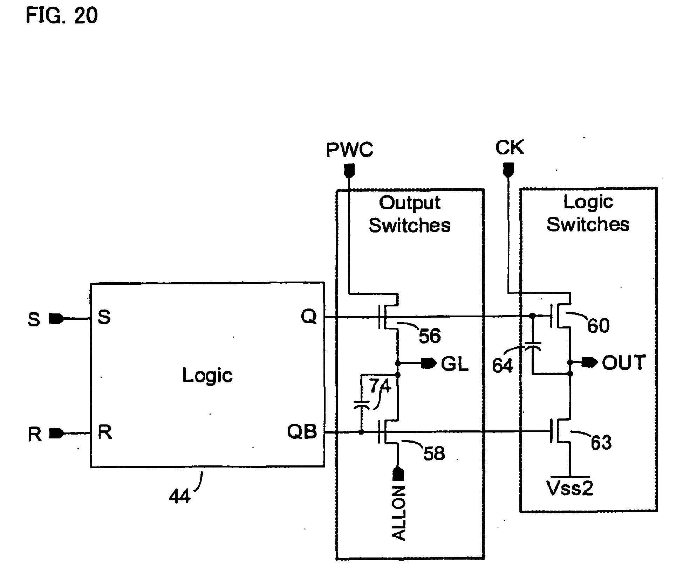

A driver with an all-on function and a partial mode of operation is shown in Figures 19 and 20. The scan driver is composed of a number of stages, 82. Each stage has inputs R, S, CK, PWC and ALLON. The CK inputs of odd-number stages such as 82₁ and 82₃ are connected to a first clock, CK1; the CK inputs of even-number stages such as 82₂ and 82₄ are connected to a second clock, CK2. The PWC inputs of odd-number stages are connected to a first pulse width control signal, PWC1; the PWC inputs of even-number stages are connected to a second pulse width control signal, PWC2. The ALLON inputs of all stages are connected to a signal ALLON.

Each stage is similar to that shown in Figure 14 and only the differences will be described. The transistor 58 is connected such that its principal conduction path is between the ALLON input and the GL output. In addition, there is a bootstrap capacitor 74 connected between the GL output and the QB output of the logic. As before, this serves to ensure the voltage on the control electrode of the transistor 58 is boosted to a level sufficient for the high level of ALLON to conduct fully to the GL output.

In normal mode, ALLON is held at a low voltage, such as Vss1, and the driver operates as described hereinbefore. In the "all on" mode, ALLON is held at a high voltage.

The above embodiments and examples have been described with respect to a scan driver for an active matrix display composed of only n-type transistors. It will be obvious to one skilled in the art that all embodiments may equally be applied to a data driver or to a circuit composed of only p-type transistors or of both n- and p-type transistors.

## Claims

1. A shift register comprising a plurality of stages (62) arranged to be activated in sequence, each stage (62) comprising a logic circuit (44) controlling first and second output circuits, the first output circuit comprising a stage output (GL) for supplying an output signal of the stage (63) and the second output circuit comprising a further output (OUT) of the stage (62) connected to a set input (S) of the logic circuit (44) of a succeeding stage (62) and connected to a reset input (R) of the logic circuit (44) of a preceding stage (62), the first output circuit comprising a first switch (56), which connects the stage output (GL) to a first active signal input of the stage (62) when the stage is active, and a second switch (58), which connects the stage output (GL) to a first inactive signal input of the stage (62) when the stage is inactive,
wherein the second output circuit comprises a third switch (60), which connects the further output (OUT) of the stage (62) to a second active signal input of the stage (62) when the stage is active, and a fourth switch (63), which connects the further output (OUT) to a second inactive signal input of the stage when the stage is inactive;
and wherein the second active signal input is connected to at least one clock input (CK) of the register;
**characterized by** the first active signal inputs of at least some of the stages (62) being connected to at least one pulse width control input of the register for receiving at least one pulse width control signal (PWC) for determining which of the stages (62) is enabled.

2. A shift register as claimed in claim 1, in which the first active signal inputs of at least some of the stages are connected to at least one clock input of the register.

3. A shift register as claimed in claim 1 or 2, in which the first inactive signal inputs of at least some of the stages are connected to a control input of the shift register for receiving an inactive signal level in a first mode of operation and an active signal level in a second mode of operation for activating the stage outputs of the at least some stages simultaneously, or in which the first inactive signal inputs are connected to receive an inactive signal level.

4. A shift register as claimed in claim 1, in which the second inactive signal input are connected to receive an inactive signal level.

5. A shift register as claimed in any one of the preceding claims, in which each of the switches comprises an amplifying device.

6. A shift register as claimed in claim 5, in which each of the amplifying devices comprises a transistor.

7. A shift register as claimed in claim 5 or 6, in which the amplifying device constituting the first switch is provided with a first bootstrap capacitor.

8. A shift register as claimed in any one of claims 5 to 7, in which the amplifying device constituting the third switch is provided with a second bootstrap capacitor.

9. A shift register as claimed in any one of claims 5 to 8, in which the amplifying device constituting the second switch is provided with a third bootstrap capacitor.

10. A shift register as claimed in any one of the preceding claims, in which each of the logic circuits comprises a reset-set flip-flop.

11. A display driver comprising a shift register as claimed in any one of the preceding claims.

12. An active matrix display including a display driver as claimed in claim 11.

13. A display as claimed in claim 12, comprising a liquid crystal display and/or comprising addressing electrodes connected to the stage outputs.

## Patentansprüche

1. Schieberegister mit mehreren Stufen (62), die angeordnet sind, um nacheinander aktiviert zu werden, wobei jede Stufe (62) eine Logikschaltung (44) enthält, die eine erste und eine zweite Ausgangsschaltung steuert, wobei die erste Ausgangsschaltung einen Stufenausgang (GL) zum Liefern eines Aufsgangssignals der Stufe (62) enthält und die zweite Ausgangsschaltung einen weiteren Ausgang (OUT) der Stufe (62), der mit einem Setz-Eingang (S) der Logikschaltung (44) einer nachfolgenden Stufe (62) verbunden ist und mit einem Rücksetz-Eingang (R) der Logikschaltung (44) einer vorhergehenden Stufe (62) verbunden ist, enthält, wobei die erste Ausgangsschaltung einen ersten Schalter (56), der den Stufenausgang (GL) mit einem ersten aktiven Signaleingang der Stufe (62) verbindet, wenn die Stufe aktiv ist, und einen zweiten Schalter (58), der den Stufenausgang (GL) mit einem ersten inaktiven Signaleingang der Stufe (62) verbindet, wenn die Stufe inaktiv ist, enthält,
wobei die zweite Ausgangsschaltung einen dritten Schalter (60), der den weiteren Ausgang (OUT) der Stufe (62) mit einem zweiten aktiven Signaleingang der Stufe (62) verbindet, wenn die Stufe aktiv ist, und einen vierten Schalter (63), der den weiteren Ausgang (OUT) mit einem zweiten inaktiven Signaleingang der Stufe verbindet, wenn die Stufe inaktiv ist, enthält;
und wobei der zweite aktive Signaleingang mit wenigstens einem Takteingang (CK) des Registers verbunden ist;
**dadurch gekennzeichnet, dass**
die ersten aktiven Signaleingänge wenigstens einiger der Stufen (62) mit wenigstens einem Impulsbreiten-Steuereingang des Registers verbunden sind, um wenigstens ein Impulsbreiten-Steuersignal (PWC) zu empfangen, um zu bestimmen, welche der Stufen (62) freigegeben ist.

2. Schieberegister nach Anspruch 1, wobei die ersten aktiven Signaleingänge wenigstens einiger der Stufen mit wenigstens einem Takteingang des Registers verbunden sind.

3. Schieberegister nach Anspruch 1 oder 2, wobei die ersten inaktiven Signaleingänge wenigstens einiger der Stufen mit einem Steuereingang des Schieberegisters verbunden sind, um in einer ersten Betriebsart einen inaktiven Signalpegel und in einer zweiten Betriebsart einen aktiven Signalpegel zu empfangen, um die Stufenausgänge der wenigstens einigen Stufen gleichzeitig zu aktivieren, oder wobei die ersten inaktiven Signaleingänge angeschlossen sind, um einen inaktiven Signalpegel zu empfanden.

4. Schieberegister nach Anspruch 1, wobei die zweiten inaktiven Sigtialeingänge angeschlossen sind, um einen inaktiven Signalpegel zu empfangen.

5. Schieberegister nach einem der vorhergehenden Ansprüche, wobei jeder der Schalter eine Verstärkungsvorrichtung aufweist

6. Schieberegister nach Anspruch 5, wobei jede der Verstärkungavorrichtungen einen Transistor aufweist.

7. Schieberegister nach Anspruch 5 oder 6, wobei die Verstärkungsvorrichtung, die den ersten Schalter bildet, mit einem ersten Bootstrap-Kondensator versehen ist.

8. Schieberegister nach einem der Ansprüche 5 bis 7, wobei die Verstärkungsvorrichtung, die den dritten Schalter bildet, mit einem zweiten Bootstrap-Kondensator versehen ist.

9. Schieberegister nach einem der Ansprüche 5 bis 8, wobei die Verstärkungsvorrichtung, die den zweiten Schalter bildet, mit einem dritten Bootstrap-Kondensator versehen ist.

10. Schieberegister nach einem der vorhergehenden Ansprüche, wobei jede der Logikschaltungen ein Rücksetz-/Setz-Flipflop aufweist.

11. Anzeigetreiber, der ein Schieberegister nach einem der vorhergehenden Ansprüche enthält.

12. Aktivmatrixanzeige, die einen Anzeigetreiber nach Anspruch 11 enthält.

13. Anzeige nach Anspruch 12, die eine Flüssigkristallanzeige und/oder Adressierungselektroden, die mit den Stufenausgängen verbunden sind, enthält.

## Revendications

1. Registre à décalage comprenant une pluralité d'étages (62) agencés pour être activés séquentiellement, chaque étage (62) comprenant un circuit logique (44) commandant des premier et deuxième circuits de sortie, le premier circuit de sortie comprenant une sortie d'étage (GL) pour délivrer un signal de sortie de l'étage (62) et le deuxième circuit de sortie comprenant une autre sortie (OUT) de l'étage (62) connectée à une entrée de positionnement (S) du circuit logique (44) d'un étage (62) suivant et connectée à une entrée de réinitialisation (R) du circuit logique (44) d'un étage (62) précédent, le premier circuit de sortie comprenant un premier commutateur (56), qui connecte la sortie d'étage (GL) à une première entrée de signal active de l'étage (62) lorsque l'étage est actif, et un deuxième commutateur (58), qui connecte la sortie d'étage (GL) à une première entrée de signal inactive de l'étage (62) lorsque l'étage est inactif,
dans lequel le deuxième circuit de sortie comprend un troisième commutateur (60), qui connecte l'autre sortie (OUT) de l'étage (62) à une deuxième entrée de signal active de l'étage (62) lorsque l'étage est actif, et un quatrième commutateur (63), qui connecte l'autre sortie (OUT) à une deuxième entrée de signal inactive de l'étage lorsque l'étage est inactif ;
et dans lequel la deuxième entrée de signal active est connectée à au moins une entrée d'horloge (CK) du registre ;
**caractérisé en ce que**
les premières entrées de signal actives d'au moins certains des étages (62) sont connectées à au moins une entrée de commande de durée d'impulsion du registre pour recevoir au moins un signal de commande de durée d'impulsion (PWC) pour déterminer lequel des étages (62) est activé.

2. Registre à décalage selon la revendication 1, dans lequel les premières entrées de signal actives d'au moins certains des étages sont connectées à au moins une entrée d'horloge du registre.

3. Registre à décalage selon la revendication 1 ou 2, dans lequel les premières entrées de signal inactives d'au moins certains des étages sont connectées à une entrée de commande du registre à décalage pour recevoir un niveau de signal inactif dans un premier mode de fonctionnement et un niveau de signal actif dans un deuxième mode de fonctionnement pour activer les sorties d'étage d'au moins certains étages simultanément, ou dans lequel les premières entrées de signal inactives sont connectées pour recevoir un niveau de signal inactif.

4. Registre à décalage selon la revendication 1, dans lequel les deuxièmes entrées de signal inactives sont connectées pour recevoir un niveau de signal inactif.

5. Registre à décalage selon l'une quelconque des revendications précédentes, dans lequel chacun des commutateurs comprend un dispositif d'amplification.

6. Registre à décalage selon la revendication 5, dans lequel chacun des dispositifs d'amplification comprend un transistor.

7. Registre à décalage selon les revendications 5 ou 6, dans lequel le dispositif d'amplification constituant le premier commutateur est pourvu d'un premier condensateur d'amorçage.

8. Registre à décalage selon l'une quelconque des revendications 5 à 7, dans lequel le dispositif d'amplification constituant le troisième commutateur est pourvu d'un deuxième condensateur d'amorçage.

9. Registre à décalage selon l'une quelconque des revendications 5 à 8, dans lequel le dispositif d'amplification constituant le deuxième commutateur est pourvu d'un troisième condensateur d'amorçage.

10. Registre à décalage selon l'une quelconque des revendications précédentes, dans lequel chacun des circuits logiques comprend une bascule bistable à réinitialisation-positionnement.

11. Dispositif de commande d'afficheur comprenant un registre à décalage selon l'une quelconque des revendications précédentes.

12. Afficheur à matrice active comprenant un dispositif de commande d'afficheur selon la revendication 11.

13. Afficheur selon la revendication 12, comprenant un afficheur à cristaux liquides et/ou comprenant des électrodes d'adressage connectées aux sorties d'étage.
